Europäisches Patentamt

European Patent Office

Office européen des brevets

(11) Publication number: **0 064 613**

**B1**

# (12) EUROPEAN PATENT SPECIFICATION

(45) Date of publication of patent specification: **29.10.86**

(51) Int. Cl.⁴: **H 01 L 29/08, H 01 L 29/06**

(21) Application number: **82103227.3**

(22) Date of filing: **16.04.82**

(54) Semiconductor device having a plurality of element units operable in parallel.

(30) Priority: **30.04.81 JP 65934/81**
**30.04.81 JP 65952/81**

(43) Date of publication of application:
**17.11.82 Bulletin 82/46**

(45) Publication of the grant of the patent:
**29.10.86 Bulletin 86/44**

(84) Designated Contracting States:
**CH DE LI**

(56) References cited:
**DE-A-2 719 219**
**DE-A-2 802 843**
**DE-A-2 825 794**
**GB-A-2 017 401**
**GB-A-2 040 568**
**US-A-3 462 658**
**US-A-4 127 863**
**US-A-4 205 332**

The file contains technical information
submitted after the application was filed and
not included in this specification

(73) Proprietor: **Kabushiki Kaisha Toshiba**
**72, Horikawa-cho Saiwai-ku**
**Kawasaki-shi Kanagawa-ken 210 (JP)**

(72) Inventor: **Makoto, Azuma**
**205 Nakakibogaoka**
**Asahi-ku Yokohama-shi (JP)**

(74) Representative: **Henkel, Feiler, Hänzel & Partner**
**Möhlstrasse 37**
**D-8000 München 80 (DE)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

## Description

The present invention relates to a thyristor device and, more particularly, to a structure for improving the current balance between element units when a plurality of parallel element units are driven.

In a semiconductor device having a plurality of element units, different currents flow through the respective element units when these element units are operated in parallel to each other. The current may concentrate in the part of the element unit where it is easiest for the current to flow, and this may damage the element unit. This phenomenon will be more specifically described taking as examples a gate turn-off thyristor and transistors of a comb-shaped emitter structure and a multi-emitter structure.

A gate turn-off thyristor (to be referred to as a GTO for brevity hereinafter) is a four-layered semiconductor device which is similar to a general thyristor in that the gate electrode is maintained at a positive potential to allow flow of a gate current and to trigger the device. The thyristor of the general type is turned off by commutating the main current by way of a commutation circuit. In contrast to this, the GTO is turned off by maintaining the gate electrode at a negative potential to allow a negative current flow. Since the commutation circuit requires space and cost for the applied device and renders the overall device complex in structure, omission of the commutation circuit is considerably advantageous. When the devices' characteristics are considered, the turn-off time of the GTO is significantly shorter than that of the general thyristor. The GTO is, therefore, receiving more attention.

The GTO has an inherent problem of current concentration during the turn-off operation. The current concentration basically involves two modes. One mode occurs inside each element unit which constitutes the GTO. The other mode occurs between the element units. The former mode occurs in the initial to intermediate stages of the turn-off period. In this former mode, when a gate turn-off signal is applied to the gate electrode, the parts of the cathode region closer to the gate are rendered nonconductive first. Then, the current is directed to the central part of the cathode region and finally flows only through this part. The latter mode occurs in the final stage of the turn-off period. Depending upon the distribution of the impurity concentration and the difference in the carrier life times, the element unit of a larger resistance turns off at an early stage while the element unit of a smaller resistance turns off later. Therefore, at the final stage of the turn-off operation, the overall current concentrates in one or several element units. When the gate current becomes smaller than the minimum value which is required for the turn off and will be damaged by the excessive thermal loss.

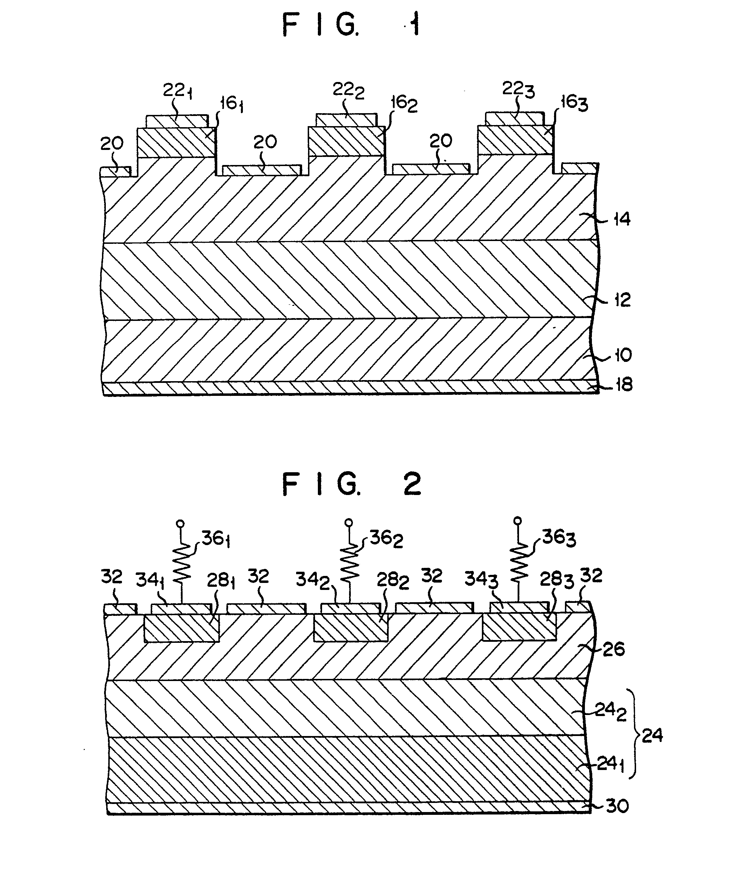

Conventionally, this problem is partially solved by adopting the structure, the partial sectional view of which is shown in Fig. 1. Referring to Fig. 1, an n-type first base layer 12 is formed to be contiguous with a p-type first emitter layer 10 to form a p-n junction therewith. A p-type second base layer 14 is formed to be contiguous with the n-type first base layer 12 to form another p-n junction therewith. A plurality of divided n-type second emitter layers 16 ($16_1$, $16_2$,..., $16_n$) are formed on the surface of the second base layer 14. An anode electrode 18, a gate electrode 20, and cathode electrodes 22 ($22_1$, $22_2$,..., $22_n$) are formed on the surface of the structure as shown in Fig. 1. The second emitter layers 16 are obtained by dividing the original layer into a plurality of layers by mesa etching. The second emitter layers 16 are divided in order to decrease the voltage drop, which is determined by the product of the base current flowing through the second base layer 14 during the turn-off operation and the lateral resistance RB, and in order to increase the gate current flow at a given gate voltage. If the gate current can be increased, the anode current which can be controlled by gate may be increased. In other words, the current concentration in the divided individual element unit may be reduced to the minimum if the lateral resistance RB is decreased. In order to decrease the lateral resistance RB, the second emitter layers are thus divided. Alternatively, it is also possible to increase the impurity concentration of the second base layer 14 to thereby reduce the sheet resistance of this layer 14. It is also possible to further divide the second emitter layers 16 to thereby reduce the distance between the emitter and the gate. Conventionally, one of these measures is taken to alleviate the current concentration in the individual element units to increase the maximum controllable anode current. However, these measures have limitations and cannot prevent the concentration of the overall current in one or several element units at the final stage of the turn-off operation. This indicates that these measures cannot prevent the current concentration between the element units.

A case will now be described with reference to a transistor of a comb-shaped emitter structure or a multi-emitter structure.

In a transistor of a comb-shaped emitter structure or a multi-emitter structure with a plurality of divided emitters, currents of different values flow through the individual element units. This is partially attributable to the nonuniformities in the impurity concentration distribution and the minority carrier life time distribution or to the crystal defects which are randomly located in the semiconductor device. This is also attributable to the fact that the emitters and the base interleave with each other so that the resistances of the electrode wirings connecting the electrode lead wires and the respective element units differ from one element unit to another. In an element unit which easily allows the flow of current, the temperature rises higher than the temperature of the other element units according to the power consumption, which is expressed by the product of the collector voltage and the collector current. As the temperature rises the base-emitter voltage of the element unit decreases, so that the current increases. This positive feedback is repeated, until the temperature exceeds the critical temperature for maintaining the p-n junction, and the transistor loses its function.

Conventionally, this problem is partially solved by adopting the structure, the partial sectional view of which is shown in Fig. 2. Referring to Fig. 2, a collector layer 24 comprises an $n^+$-type layer $24_1$ of high impurity concentration and an n-type layer $24_2$ of low impurity concentration. A p-type base layer 26 is formed thereover to form a p-n junction therewith. A plurality of n-type divided emitter layers 28 $(28_1, 28_2,..., 28_n)$ are formed thereover, forming p-n junctions. A collector electrode 30, a base electrode 32 and emitter electrodes 34 $(34_1, 34_2,..., 34_n)$ are formed as shown in Fig. 2. Resistors 36 $(36_1, 36_2,..., 36_n)$ of, for example, polycrystalline silicon thin films are series-connected with the respective emitter electrodes 34. The resistance of the resistors 36 is set to be the same as or more than the resistance between the collector electrode 30 and the emitter electrodes 34. By the incorporation of these resistors 36, variations in the element units inside the semiconductor device are reduced to make the current distribution more uniform.

This emitter ballast resistor method as adopted in the above case does not decrease the emitter area and is high in efficiency. However, this method presents a problem in the manufacturing process, especially, in the control of the resistance. For example, in order to form a thin film resistor of 0.5 μm (5,000 Å) thick on a rectangular electrode of 100 micrometers (μm) × 500 micrometers (μm), the sheet resistance of the thin film becomes $10^6$ Ω/□ if the resistance is set to 5 ohms(Ω). It is extremely difficult to control such high sheet resistance with good repeatability, so that the yield rate of the transistor with the same emitter-collector saturation voltage becomes small. Even if this problem is overcome, the current concentration cannot be completely avoided, especially since this method is incapable of preventing the concentration of the current flowing in the lateral direction of the base layer 26.

Document US—A—4,127,863 discloses a gate turn-off type thyristor which comprises a semiconductor body having four sequentially contiguous layers, adjacent two of which are of opposite conductivity type and form a PN junction therebetween. One outer layer constituting a cathode layer of said semiconductor body is divided into a plurality of mutually independent layer portions. First, second and third electrodes contact the cathode layer, the layer beneath the cathode layer and the layer opposite to the cathode layer, respectively.

Furthermore, document US—A—4,205,332 discloses a junction transistor which is provided with an ancillary layer of the same conductivity type as the emitter layer to accelerate the sweep-out of minority carriers at the instant of cutoff, the ancillary and the base layers being bridged by a common metallic contact layer. The ancillary layer, which may be divided into several zones, is wholly surrounded by the base layer so as to be bounded by one or more closed lines along a body surface carrying contact layer, the latter partly or completely overlying these lines. The ancillary and emitter layers may be formed in a single diffusion step through a common mask.

Finally, document GB—A—2,040,568 describes a transistor formed in a semiconductor body. This transistor has connection conductors which are doped parts of a polycristalline semiconductor layer extending over an insulating layer which has an aperture exposing the semiconductor body. The semiconductor layer extends into this aperture so that the doped parts adjoin the zones of the transistor. During the manufacture, after the semiconductor layer has been provided over the insulating layer and in the aperture, at least two local doping treatments are carried out to form the different parts of the semiconductor layer. During these doping treatments the edge of the aperture always remain covered and so the aperture does not become enlarged by an edging treatment which is carried out immediately before each doping treatment. This enables the PN junctions between the zones to be formed close together so that particularly compact devices can be made.

It is an object of the present invention to provide a thyristor device which improves the current balance between respective element units, prevents excessive current concentration in a particular element unit, and is improved in reliability.

This object has been achieved by a thyristor device having a plurality of element units, said thyristor device comprising: a first emitter layer of the first conductivity type, a first base layer of a second conductivity type formed on said first emitter layer, a second base layer of said first conductivity type formed on said first base layer, a plurality of second emitter layers of said second conductivity type arranged on a surface of said second base layer, each one of said second emitter layers being both mesa-type and provided for one of said element units, and electrodes which are in ohmic contact to the first emitter layer, to the second base layer and to the plurality of second emitter layers, respectively, said plurality of element units being operable parallel to each other, and the electrodes of the second base layer being located between at least each pair of the second emitter layers said thyristor device being characterized in that a diffusion semiconductor layer of said second conductivity type and for suppressing a current is provided in the second base layer between each pair of second emitter layers in the direct vicinity of the electrodes in ohmic contact with the second base layer, and extends into only said second base layer.

According to the present invention, a current suppressing layer for suppressing the base current flowing between the element units in the lateral direction is formed in the base layer region between each pair of emitter layers. Therefore, the current concentration in a particular element unit may be effectively prevented.

By way of example and to make the description clearer, reference is made to the accompanying drawings, in which:

Fig. 1 is a partial sectional view of a conventional gate turn-off thyristor;

Fig. 2 is a partial sectional view of a conventional transistor; and

Fig. 3 is a partial sectional view of a gate turn-off thyristor according to an embodiment of the present invention.

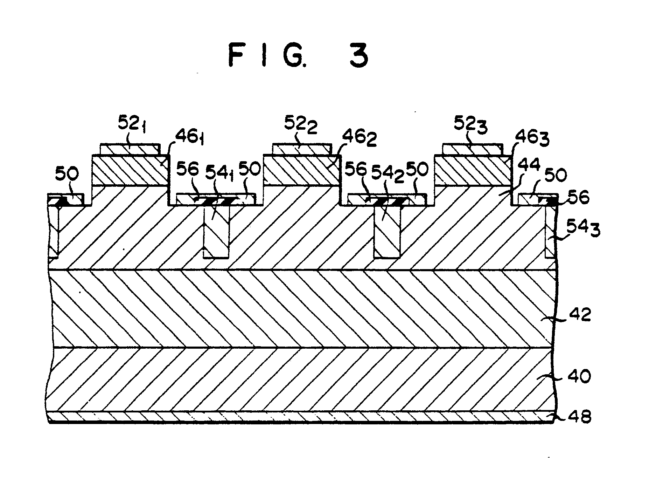

Fig. 3 is a partial sectional view of a gate turn-off thyristor (to be referred to as a GTO for brevity hereinafter) according to an embodiment of the present invention. As shown in Fig. 3, a p-type first emitter layer 40, an n-type first base layer 42 and a p-type second base layer 44 are sequentially formed in the order named. On the surface of the second base layer 44 a plurality of divided, mesa n-type second emitter layers 46 ($46_1$, $46_2$,..., $46_n$) are formed to define a plurality of element units. An anode electrode 48, a gate electrode 50 and cathode electrodes 52 ($52_1$, $52_2$,..., $52_n$) are formed in ohmic contact with the first emitter layer 40, the second base layer 44, and the second emitter layer 46. In the regions of the second base layer 44 which are between the second emitter layers 46, n-type layers 54 ($54_1$, $54_2$,..., $54_n$) are formed as current suppressing layers for suppressing the lateral base current. Each n-type layer 54 is at substantially an equal distance from the adjacent second emitter layers 46. The depth of each n-type layer 54 is set so that the n-type layer 54 does not reach the first base layer 42. An insulation film 56 of, for example, $SiO_2$ or $Si_3N_4$ may be formed on the surface of each n-type layer 54 to improve noise capability, however, its use is optional.

The effects of this embodiment will now be described. The GTO of this embodiment is characterized in that the n-type layer 54, formed inside the p-type second base layer 44, cuts off the lateral base current which flows through the second base element 44 during the turn-off operation. According to the experiments conducted, in a conventional GTO having an average impurity concentration of $4 \times 10^{17}$ cm$^{-3}$ in the second base layer, the lateral resistance RB gradually increases as the turn-off operation progresses if the lateral resistance of the second base layer in the initial stage of the turn-off operation is 0.05 Ω. In the final stage of the turn-off operation, the lateral resistance RB becomes 0.3 Ω. This indicates that the excess carriers which are stored in the second base layer are gradually excluded through the gate electrode. The anode-cathode resistance RAC is about 1 Ω under the conductive condition. This anode-cathode resistance RAC abruptly increases to about 10 times its original value during the turn-off operation. During the turn-off operation, the lateral resistance RB is negligible compared to the anode-cathode resistance RAC. Therefore, if the anode-cathode resistance RAC differs from one element unit to another, the current flows from an element unit with greater RAC to an element unit with smaller RAC through the second base layer 44. The anode-cathode resistance RAC is determined by the impurity concentration distribution and the minority carrier life time of the base or the like. In practice, it is almost impossible to make these characteristics uniform from one element unit to another. Therefore, this phenomenon occurs with the conventional GTO almost without failure. In contrast to this, in the GTO of the structure according to the embodiment of the present invention, since the n-type layer 54 is formed immediately below the gate electrode 50, the lateral resistance of the second base layer 44 is increased accordingly. Then, it becomes difficult for the current to flow in the lateral direction of the second base layer 44. Specifically, with reference to Fig. 3, the second emitter layer 46 has a surface impurity concentration of $4 \times 10^{20}$ cm$^{-3}$. The second base layer 44 and the first emitter layer 40 have a surface impurity concentration of $2 \times 10^{18}$ cm$^{-3}$. The first base layer 42 has an average impurity concentration of $8 \times 10^{13}$ cm$^{-3}$. The depth of the second emitter layer 46 from the surface is 10 μm, and that of the second base layer 44 is 60 μm. Then, the sheet resistance of the second base layer 44 is 31 Ω/□. The n-type layers 54 are formed to depths of 30, 40 and 50 μm in the second base layer 44. The sheet resistances of the second base layers 44 into which the n-type layers 54 extend become 265, 1,904 and 4,044 Ω/ , respectively. Thus, the resistance of that part of the second base layer 44 corresponding to the n-type layer 54 which is 50 μm deep from the surface becomes about 130 times that of that part of the second base layer 44 which is immediately below the cathode electrode 52. During the turn-off period, the second base layer 44 is still a high impurity concentration layer. Therefore, the resistance may be discussed only in terms of the sheet resistance. However, according to this embodiment, the resistance between each pair of element units is about 40 ohms. This value is about the same or slightly greater than the anode-cathode resistance RAC during the turn-off period, so that substantially no current flows between the element units through the second base layer 44. In other words, the current may not concentrate in a particular element unit during the turn-off period. In practice, with a GTO of this embodiment, it is possible to provide an anode current flow which allows gate control and which is about five times greater than that obtainable with the GTO of the conventional structure. Furthermore, since the parts of the second base layer 44 below the cathode electrode and the cathode region are the same as those of the GTO of the conventional structure, other characteristics remain the same. The advantageous effects of the present invention may be more pronounced if a ballast resistor made of a resistor film or a polycrystalline silicon film is connected to the cathode electrode 52. This is attributable to the fact that variations in the element units of the semiconductor substrate are improved by the ballast resistance, and the current concentration may hardly occur due to the current cut-off region inside the second base layer 44.

The GTO of this embodiment may be manufactured by the procedure to be described below. A semiconductor wafer for the substrate has a specific resistivity of 10 to 300 $\Omega \cdot$cm, and has a thickness of 0.2 to 1.2 mm, and contains an n-type impurity such as phosphorus (P). Although the specific resistivity and thickness of the semiconductor wafer may be selected within the relatively wider ranges as given above, they must be appropriately selected according to the off-state voltage rating of the GTO. The off-state voltage rating obtainable with the impurity concentration and the width, in the ranges as given above, is within the range of 300 to 6,000 V. A p-type impurity such as gallium (Ga) or boron (B) is doped from both major surfaces of the semiconductor wafer to form a first base layer 42 and to form a first emitter layer 40 and a second base layer 44 having a surface impurity concentration of $10^{17}$ to $10^{19}$ cm$^{-3}$ and a thickness of 30 to 80 $\mu$m. A three-layered pnp structure is thus obtained. After depositing a masking material such as $SiO_2$ on the major surface, part of the gate is removed by photolithography or etching to form a contact hole. An n-type impurity such as $POCl_3$ or $PH_3$ is diffused through this contact hole into the second base layer 44 to form an n$^+$-type layer therein. After depositing the masking material such as $SiO_2$ or the like again, an n-type impurity is diffused in the cathode region in a similar manner to form a second emitter layer 46. The etching depth of the gate part and the diffusion depth of the n$^+$-type layer to be formed therein are determined by the depth of the original base diffusion layer. However, the deeper the n$^+$-type layer is formed, the better the results obtained. However, if the n$^+$-type layer reaches the p-n junction formed by two bases, acceptable off-state voltage rating may not be obtained. Therefore, the n$^+$-type layer must be formed to be shallower than the p-n junction. The subsequent steps are obvious to the skilled in the art, and the description thereof will therefore be omitted.

The cathode-gate junction may be of the planar type as well as of the mesa type. In the case of the planar type cathode-gate junction, the step for etching the gate part may be omitted. If the p-n junction formed by two bases is relatively shallow, the second emitter layer 46 and the n$^+$-type layer as the current suppressing layer may be formed simultaneously. In this case, the number of manufacturing steps will be less than in the conventional case, resulting in high manufacturing efficiency.

According to the embodiment of the present invention, in a GTO with a plurality of element units, the current concentration in a particular element unit during the turn-off operation is prevented, and the switching operation may be performed with high reliability.

## Claims

1. A thyristor device having a plurality of element units, said thyristor device comprising:

a first emitter layer (40) of a first conductivity type;

a first base layer (42) of a second conductivity type formed on said first emitter layer;

a second base layer (44) of said first conductivity type formed on said first base layer;

a plurality of second emitter layers (46$_1$, 46$_2$, 46$_3$) of said second conductivity type arranged on a surface of said second base layer (44), each one of said second emitter layers being of mesa type and provided for one of said element units; and

electrodes (48, 50, 52, 52$_1$, 52$_3$) which are in ohmic contact to the first emitter layer (40), to the second base layer (44) and to the plurality of second emitter layers (46$_1$, 46$_2$, 46$_3$) respectively,

said plurality of element units being operable parallel to each other, and

the electrodes (50) of the second base layer (44) being located between at least each pair of the second emitter layers (46$_1$, 46$_2$, 46$_3$),

characterized in that

a diffusion semiconductor layer (54$_1$, 54$_2$, 54$_3$) of said second conductivity type and for suppressing a current is provided in the second base layer (44) between each pair of second emitter layers (46$_1$, 46$_2$, 46$_3$) in the direct vicinity of the electrodes (50) in ohmic contact with the second base layer (44), and extends into only said second base layer (44).

2. The thyristor device according to claim 1, characterized in that said diffusion semiconductor layer (54$_1$, 54$_2$, 54$_3$) is spaced apart from the electrode (50) of the second base layer (44) with an insulation layer (56) interposed therebetween.

## Patentansprüche

1. Thyristoranordnung mit einer Vielzahl von Einzelelementen, umfassend

eine erste Emitterschicht (40) eines ersten Leitfähigkeitstyps,

eine auf der ersten Emitterschicht ausgebildete erste Basisschicht (42) eines zweiten Leitfähigkeitstyps,

eine auf der ersten Basisschicht vorgesehene zweite Basisschicht (44) des ersten Leitfähigkeitstyps,

eine Vielzahl von auf einer Oberfläche der zweiten Basisschicht (44) angeordneten zweiten Emitterschichten (46$_1$, 46$_2$, 46$_3$) des zweiten Leitfähigkeitstyps, wobei jede der zweiten Emitterschichten vom Mesatyp und für (je) eines der Einzelelemente vorgesehen ist, und

Elektroden (48, 50, 52, 52$_1$, 52$_3$), die in ohmschem Kontakt mit der ersten Emitterschicht (40), der zweiten Basisschicht (44) bzw. der Vielzahl zweiter Emitterschichten (46$_1$, 46$_2$, 46$_3$) stehen,

wobei die Vielzahl der Einzelelemente parallel zueinander betätigbar sind und

die Elektroden (50) der zweiten Basisschicht (44) (jeweils) zwischen mindestens zwei der zweiten Emitterschichten (46$_1$, 46$_2$, 46$_3$) angeordnet sind,

dadurch gekennzeichnet, daß

eine zur Unterdrückung oder zum Sperren eines Stroms dienende Diffusionshalbleiterschicht ($54_1$, $54_2$, $54_3$) des zweiten Leitfähigkeitstyps in der zweiten Basisschicht (44) zwischen je zwei zweiten Emitterschichten ($46_1$, $46_2$, $46_3$) in unmittelbarer Nähe der mit der zweiten Basisschicht (44) in ohmschem Kontakt stehenden Elektroden (50) vorgesehen ist und sich nur in die zweite Basisschicht (44) hinein erstreckt.

2. Thyristoranordnung nach Anspruch 1, dadurch gekennzeichnet, daß die Diffusionshalbleiterschicht ($54_1$, $54_2$, $54_3$) unter Zwischenfügung einer Isolierschicht (56) auf Abstand von der Elektrode (50) der zweiten Basisschicht (44) angeordnet ist.

**Revendications**

1. Dispositif formant thyristor, comportant une pluralité d'éléments, ledit dispositif formant thyristor comprenant:

— une première couche d'émetteur (40) d'un premier type de conductivité;

— une première couche de base (42) d'un second type de conductivité, formée sur ladite première couche d'émetteur;

— une seconde couche de base (44) dudit premier type de conductivité, formée sur ladite première couche de base;

— une pluralité de secondes couches d'émetteur ($46_1$, $46_2$, $46_3$) dudit second type de conductivité, placées sur une surface de ladite seconde couche de base (44), chacune desdites secondes couches d'émetteur étant de type mésa et étant prévue pour un desdits éléments; et

— des électrodes (48, 50, 52, $52_1$, $52_3$) qui sont en contact ohmique avec la première couche d'émetteur (40), avec la second couche de base (44) et avec la pluralité de secondes couches d'émetteur ($46_1$, $46_2$, $46_3$), respectivement,

— ladite pluralité d'éléments pouvant opérer mutuellement en parallèle, et

— les électrodes (50) de la seconde couche de base (44) étant placées entre des secondes couches d'émetteur d'au moins chaque paire ($46_1$, $46_2$, $46_3$),

caractérisé en ce que

— une couche semiconductrice de diffusion ($54_1$, $54_2$, $54_3$) dudit second type de conductivité, servant à une suppression de courant, est prévue dans la seconde couche de base (44) entre les secondes couches d'émetteur de chaque paire ($46_1$, $46_2$, $46_3$) au voisinage direct des électrodes (50) en contact ohmique avec la seconde couche de base (44), et s'étend seulement dans ladite seconde couche de base (44).

2. Le dispositif formant thyristor selon la revendication 1, caractérisé en ce que ladite couche semiconductrice de diffusion ($54_1$, $54_2$, $54_3$) est espacée de l'électrode (50) de la seconde couche de base (44), avec interposition entre elles d'une couche isolante (56).

# F I G. 1

# F I G. 2

# F I G. 3